Europäisches Patentamt

European Patent Office

Office européen des brevets

(11) Veröffentlichungsnummer: **0 046 975**
**A2**

## (12) EUROPÄISCHE PATENTANMELDUNG

(21) Anmeldenummer: **81106600.0**

(22) Anmeldetag: **25.08.81**

(51) Int. Cl.$^3$: **H 05 K 1/16**
**H 01 C 17/06, H 01 C 13/02**

(30) Priorität: **28.08.80 DE 3032492**

(43) Veröffentlichungstag der Anmeldung:
**10.03.82 Patentblatt 82/10**

(84) Benannte Vertragsstaaten:
**DE FR GB IT SE**

(71) Anmelder: **SIEMENS AKTIENGESELLSCHAFT Berlin
und München
Postfach 22 02 61
D-8000 München 22(DE)**

(72) Erfinder: **Utner, Ferdinand
Roter Brachweg 99
D-8400 Regensburg(DE)**

(72) Erfinder: **Vetter, Harald, Ing. (grad.)
Weinberg 7
D-8400 Regensburg(DE)**

(54) **Elektrisches Netzwerk und Verfahren zu seiner Herstellung.**

(57) Ein elektrisches Netzwerk, das wenigstens einen elektrischen Widerstand enthält, ist aus einer mit Kontaktflächen (3, 6) beschichteten Trägerfolie (1) aufgebaut. Auf eine Widerstandsschicht (2) ist eine Kunststoffschicht (4) aufgebracht, und die Trägerfolie (1) ist in einer Zick-Zack-Linie gefaltet. Die Kontaktflächen (3, 6) werden von äußeren Kontaktschichten (7, 8) kontaktiert.

FIG 1

EP 0 046 975 A2

SIEMENS AKTIENGESELLSCHAFT
Berlin und München

0046975

Unser Zeichen
VPA 80 P 1140 E

## Elektrisches Netzwerk und Verfahren zu seiner Herstellung.

Die vorliegende Erfindung betrifft ein elektrisches Netzwerk, welches zumindest einen elektrischen Widerstand enthält, welches aus einer mit Widerstandsschichten und mit Kontaktflächen beschichteter Trägerfolie aufgebaut ist.

Ein derartiges Netzwerk ist aus der DE-PS 17 65 511 bekannt. Dort wird auf eine Trägerfolie ein entsprechendes Muster von Widerstandsschichten und leitfähigen Schichten aufgebracht.

Die Aufgabe, die der vorliegenden Erfindung zugrundeliegt, besteht in der Darstellung eines einfach herzustellenden elektrischen Netzwerkes mit kleinen Abmessungen und hohen Widerstandswerten des elektrischen Widerstandes. Der Begriff "Netzwerk" schließt hier einen einzelnen Widerstand als einfachste Ausführung ein.

Diese Aufgabe wird bei einem Netzwerk der eingangs beschriebenen Art dadurch gelöst, daß auf die Widerstandsschichten eine Kunststoffschicht aufgebracht ist, daß die Trägerfolie so in einer Zick-Zack-Linie gefaltet ist, daß auf den beiden äußersten Lagen auf den Außenseiten der Trägerfolie je eine Kontaktfläche liegt und daß äußere Kontaktschichten so aufgebracht sind, daß sie jeweils gerade eine Kontaktfläche kontaktieren.

Aus der DE-PS 26 34 389 ist es bekannt, einen Kondensator durch Zick-Zack-Falten von metallbeschichteten Folien herzustellen. Hierzu werden die Kondensatorfolien gefaltet, jede einzelne Metallschicht der Beläge wird im Bereich der Faltkanten durch Spritzmetallschichten kontaktiert. Die Metallschichten der Beläge liegen dort auch beim symmetrischen Aufbau nicht in der Mitte der gefalteten Folie. Der dort gezeigte Aufbau ist für die Faltung von Widerstandsschichten ungeeignet, da diese meistens spröde sind.

Der erfindungsgemäße Aufbau hat die Vorteile, daß relativ lange Widerstandsbahnen in einem Widerstand mit sehr kleinen Abmes-

Mhs 1 Lk / 22.8.1980

sungen untergebracht werden können. Dadurch sind relativ hohe Widerstandswerte darstellbar, ohne daß allzu aufwendige Verfahren für die Herstellung der Widerstandsmuster eingesetzt werden müssen. Dadurch können auch relativ breite Widerstandsbahnen eingesetzt werden, welche gegen äußere Beschädigungen weniger anfällig sind, als extrem schmale Widerstandsbahnen.

Die Kontaktierung erfolgt mittels äußerer Kontaktschichten, die mit Kontaktflächen stoffschlüssig verbunden sind. Diese Kontaktflächen können sehr dünn ausgebildet sein. Sie müssen nur eine dauerhafte elektrisch leitfähige Verbindung mit den äußeren Kontaktschichten gewährleisten. Sie können beispielsweise aus Aluminium bestehen, wenn die äußeren Kontaktschichten mittels des Schoop'schen Flammspritzverfahrens aufgebracht werden sollen. Wird eine lötfähige Kontaktfläche angestrebt, so empfiehlt sich, als Kontaktflächen Kupferschichten einzusetzen. Vorteilhaft wird auch ein leitfähiger Kleber als äußere Kontaktschicht verwendet. Dies ist insbesondere bei hochohmigen Widerständen vorteilhaft, da die Leitfähigkeit derartiger Kleber für die Kontaktierung hochohmiger Widerstände voll ausreicht und da die elektrisch leitfähigen Kleber mit einfachen Mitteln aufgebracht werden können.

Ein unmittelbar in gedruckte Schaltungen einsetzbarer, sogenannter Chipkondensator weist vorteilhaft die Merkmale auf, daß die Kontaktflächen von der Kunststoffschicht nicht bedeckt sind, daß die Kontaktflächen im Bereich je einer Reihe der Faltkanten liegen und daß die äußeren Kontaktschichten jeweils eine Reihe von Faltkanten umschließen und jeweils nur eine Kontaktfläche kontaktieren, während die jeweils andere Kontaktfläche und die Faltkanten durch die Kunststoffschicht gegenüber den äußeren Kontaktschichten isoliert sind. Dieser Aufbau gewährleistet eine gute Festigkeit des Netzwerkes infolge der Klammerfunktion der äußeren Kontaktschichten, die jede einzelne Lage festhalten.

Die erwähnte Kunststoffschicht kann eine aufkaschierte Kunststoffolie oder auch eine auflackierte Kunststoffschicht sein.

Diese Kunststoffschicht weist vorteilhaft annähernd dieselbe Dicke auf, wie die Trägerfolie. Dadurch wird es ermöglicht, daß die Widerstandsschicht durch die Faltung nicht oder nur geringfügig gedehnt ist, so daß sie keine Risse oder andere Beschädigungen aufweist. Risse und Beschädigungen sind das Kriterium für eine unzulässige Abweichung der Dicke der Kunststoffschicht von der Dicke der Trägerfolie.

Die Widerstandsschicht besteht vorzugsweise aus Chrom-Nikkel. Dabei ist die im Bereich der Faltkanten erfolgte Dehnung vorteilhaft nicht größer als 3%. So werden auch bei den relativ spröden Chromnickelschichten Risse und andere Beschädigungen aufgrund der Dehnung vermieden. Die hierfür benötigten Dickeverhältnisse zwischen der Trägerfolie und der Kunststoffschicht lassen sich aus dem Biegeradius infolge der Dicke der Trägerfolie ermitteln.

Insbesondere in Fällen, in denen eine gewisse Dehnung der Widerstandsschichten unvermeidbar ist, ist es vorteilhaft, wenn die Widerstandsschicht im Bereich der Faltkanten durch ein duktiles Metall verstärkt ist. In diesem Fall können Risse in der Widerstandsschicht keine Schädigung des Netzwerkes hervorrufen, da sie durch die Schicht aus duktilem Metall überbrückt werden.

Netzwerke in der hier beschriebenen Art umfassen einzelne Widerstände. Sollen die Netzwerke mehr als ein Bauelement umfassen, so ist es vorteilhaft, daß das Netzwerk zumindest zwei nebeneinander liegende Kontaktflächen aufweist und daß Schlitze durch die äußeren Kontaktschichten und zwischen den nebeneinander liegenden Kontaktflächen eingebracht sind. So entstehen mehr als zwei Kontaktflächen,
die auch durch die äußeren Kontaktschichten nicht kurzgeschlossen sind. Zwischen den so entstandenen drei oder
mehr Kontaktflächen können beliebige Netzwerke insbesondere von Widerständen angeordnet werden.

Je nach Dimensionierung und Einsatzbereich kann eine Ausführungsform besonders vorteilhaft sein, in der die einzelnen Falten miteinander stoffschlüssig verbunden sind
und in der die äußeren Kontaktschichten jeweils eine der
beiden freiliegenden Oberflächen der Trägerfolie bedecken.
Dort erfassen sie jeweils eine Kontaktfläche. Die Verfestigung des Kondensators wird hierbei durch die stoffschlüssige Verbindung zwischen den Falten gewährleistet.

Ein Netzwerk der beschriebenen Art wird vorteilhaft mit
weiteren Bauelementen integriert, indem auf die Kunststoffschicht zumindest eine weitere Metallschicht und
eine weitere Kunststoffschicht aufgebracht sind, indem
die Metallschicht aus duktilem Metall besteht und weitere
Bauelemente, wie Kondensatoren und/oder Spulen bildet,
und indem die Kunststoffschicht, die weitere Kunststoffschicht und die Metallschicht zusammen etwa die Dicke
der Trägerfolie aufweisen. Bei diesem Aufbau ist wiederum
die Widerstandsschicht einer verschwindend geringen mechanischen Beanspruchung bei der Faltung ausgesetzt. Die
duktile Metallschicht dagegen verträgt eine wesentlich
größere Dehnung, als die spröde Widerstandsschicht, eine
Beschädigung durch die Faltung ist auch bei einem größeren Dickenunterschied zwischen der zweiten Kunststoffschicht und der Summe der restlichen Schichten nicht zu
befürchten. Die nun in verschiedenen Ebenen vorhandenen
Metallschichten können durch verschiedene bekannte Durchkontaktierverfahren miteinander verschaltet werden.

Zur Herstellung der erfindungsgemäßen Netzwerke eignet sich insbesondere ein Verfahren, bei dem die mit Widerstandsschichten und Kontaktflächen und ggf. weiteren Schichten versehene Trägerfolie an ihren Rändern die Kontaktflächen aufweist, indem die Kunststoffschicht unter Freilassung der Kontaktflächen aufgebracht wird, indem die Trägerfolie in ihrer Längsrichtung gefaltet wird, indem die äußeren Kontaktschichten aufgebracht werden und indem dann der so gebildete Faltstrang in einzelne Netzwerke zertrennt wird.

Bei relativ kleinen herzustellenden Stückzahlen sowie bei einem gleichgroßen Bedarf verschiedener Typen von Netzwerken ist es vorteilhaft, wenn unterschiedliche Muster von Widerstandsbahnen abwechselnd auf nur einer Trägerfolie erzeugt werden, wenn dadurch verschiedene Netzwerktypen abwechselnd hergestellt und beim Zertrennen auseinandersortiert werden.

Netzwerke mit mehr als zwei Anschlüssen werden vorteilhaft hergestellt, indem zwischen je zwei nebeneinander liegenden Kontaktflächen auf einer Seite der Trägerfolie metallfreie Streifen erzeugt werden und indem der Faltstrang nach seiner Fertigstellung innerhalb dieser metallfreien Streifen eingesägt wird.

Die Widerstandsschichten können aufgedampft oder in Siebdruckverfahren aufgebracht werden. Die Muster können beispielsweise auch durch eine selektive Ätzung aus Metallschichten herausgearbeitet werden, die die gesamte Folie bedecken. Die Schichten können beispielsweise aufgedampft, durch Kathodenzerstäubung aufgebracht, aufgedruckt werden.

Die Kontaktierung kann sowohl durch Schoopen als auch durch Verzinnen als auch durch Aufschieben von Kappen auf die Kontaktflächen als auch durch Aufkleben von Leitkleber, beispielsweise in Verbindung mit Klammern oder Kappen, erfolgen, Sofern das Netzwerk nur wenige Falten erhält, kann zur Versteifung vorteilhaft eine zusätzliche Isolierstoffolie beigespult werden. Die äußere Seite der beigespulten Isolierstoffolie oder auch die außenliegende Lage der Trägerfolie können mit einer Kleberschicht versehen sein, so daß beim Einsetzen der Netzwerke in eine größere Schaltung kein zusätzlicher Kleber oder sonstiger Befestigungsvorgang notwendig ist.

Zur besseren Verankerung der äußeren Kontaktschicht kann eine versetzte Faltung erzeugt werden, d.h. daß die Faltkanten einer Reihe gegeneinander geringfügig versetzt sind.

Sofern die Vorratsrollen breiter sind, als die für die Netzwerke benötigten Folienstreifen, werden vorteilhaft in der zur Folienlaufrichtung senkrechten Richtung zwei oder mehr Muster entsprechender Netzwerke aufgedruckt und die Folien vor dem Falten in entsprechende Streifen zertrennt. Dadurch können mehrere Netzwerkstränge gleichzeitig gefaltet und weiterverarbeitet werden.

Der Faltstrang kann entweder geradlinig weitergeführt und zu den Netzwerken vervollständigt werden oder auch auf eine Trommel mit großem Durchmesser aufgewickelt und auf dieser Trommel weiterbehandelt werden. Das Zertrennen in einzelne Netzwerke geschieht hierbei vorteilhaft durch Sägen oder Stanzen.

Auf der außenliegenden Schicht der letzten Lage der Trägerfolie ist Abgleichvorgang, beispielsweise mittels eines Laserstrahls, möglich.

Auch eine unstrukturierte Folie kann in erfindungsgemäße Netzwerke eingesetzt werden. In diesem Fall kann die Strukturierung nachträglich durch Sägeschnitte erfolgen, die von einer Kontaktfläche hergeführt sind.

Durch Messung der Schichtdaten einer beschichteten Trägerfolie kann die für einen bestimmten Widerstandswert benötigte Länge der Netzwerke bestimmt werden. Im Falle durchgehender Widerstandsschichten ist die Länge dem Leitwert
des Widerstandes proportional.

Ein vorteilhaftes Netzwerk weist mehrere parallel liegende, einseitig miteinander verbundene Widerstände auf. In
diesem Fall ist das Netzwerk einseitig eingeschnitten, so
daß auf einer Seite mehrere Kontaktflächen entstehen, an
denen jeweils ein Widerstand kontaktiert ist. Auf der gegenüberliegenden Seite sind die zweiten Anschlüsse aller
Widerstände zusammengeschaltet.

Bei Bedarf können auch Anschlußdrähte an die äußeren Kontaktschichten angebracht werden.

Die Erfindung wird nun anhand von fünf Figuren näher erläutert. Sie ist nicht auf die in den Figuren gezeigten
Beispiele beschränkt.

Fig. 1 zeigt ein erfindungsgemäßes Netzwerk in geschnittener Ansicht.
Fig. 2 zeigt eine beschichtete Trägerfolie für besonders
hohe Widerstandswerte.
Fig. 3 zeigt ein Netzwerk mit mehreren Anschlüssen.
Fig. 4 zeigt eine Folie mit mehreren parallel geschalteten Widerständen je Netzwerk.
Fig. 5 zeigt eine Folie mit zusätzlichen Schichten für die
Integration von zusätzlichen Bauelementen.

Auf eine Trägerfolie 1 ist eine gemusterte Widerstandsschicht 2 aufgebracht. Auf diese Widerstandsschicht 2
sind Kontaktflächen 3 und 6 aufgebracht. Die Trägerfolie
ist gefaltet. Im Bereich der Faltkanten 12 ist auf die
Widerstandsschicht 2 jeweils eine Verstärkung 5 aus duktilem Metall aufgebracht. Mit diesen Schichten ist eine

0046975

Kunststoffschicht 4 stoffschlüssig verbunden, welche annähernd dieselbe Dicke aufweist, wie die Trägerfolie 1. Die Kunststoffschicht 4 kann durch eine aufkaschierte Kunststoffolie oder auch eine als Lack aufgetragene Schicht sein. Die Kunststoffschicht 4 bedeckt die Kontaktflächen 3 bzw. 6 nicht vollständig. Äußere Kontaktschichten 7 bzw. 8 überdecken jeweils eine Reihe von Faltkanten 12 und reichen bis auf die freiliegenden Teile der Kontaktflächen 6 bzw. 3 und kontaktieren jeweils eine Kontaktfläche.

Dieser Aufbau gewährleistet, daß die in aller Regel relativ spröde Widerstandsschicht 2 beim Falten des Netzwerkes im Bereich der neutralen Faser liegt, also keinen unzulässigen Zugbeanspruchungen im Bereich der Faltkanten unterworfen wird. Die Verstärkung aus duktilem Metall ermöglicht auch den Einsatz besonders spröder Widerstandsschichten und eine gewisse Streuung der Dicke der Trägerfolie und der Kunststoffschicht, da sie ggf. entstehende Risse in der Widerstandsschicht überbrückt.

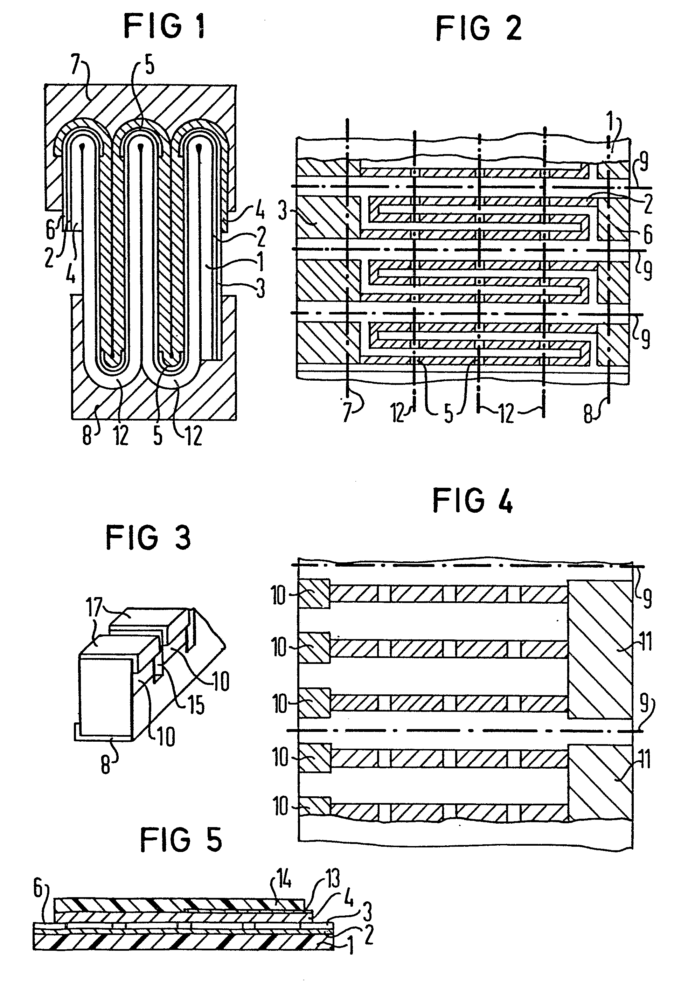

Die Kontaktflächen 3 und 6 reichen unterschiedlich weit auf jeweils eine der außen liegenden Flächen der Trägerfolie. Demgemäß sind die Kontaktflächen 3 bzw. 6 unterschiedlich dimensioniert. Die Kunststoffschicht 4 läßt dementsprechend auf den beiden Seiten der Trägerfolie 1 unterschiedlich breite Streifen frei, sie reicht bis zu den Begrenzungslinien 18 über den Kontaktflächen 3 bzw. 6, siehe Figur 2. Der von der Kunststoffschicht 4 überdeckte Bereich der Kontaktflächen 3 bzw. 6 reicht vorteilhaft bis um die zunächst liegende Faltkante 12 herum. Dadurch ergibt sich eine mechanisch besonders feste Kontaktierung insbesondere bei kleinen Abmessungen des Netzwerkes.

Die gemäß Fig. 2 mäandrierte Widerstandsschicht 2 ist zur Herstellung besonders hoher Widerstände geeignet, da die

0046975

Widerstandsbahnen in ihrem größten Teil senkrecht zu den Faltkanten verlaufen und da die Umkehrpunkte unschwer außerhalb der Faltkanten untergebracht werden können, so daß auch bei einer sehr feinen Ausführung dieses Musters keine längeren Stücke von Widerstandsbahnen mit den Faltkanten 12 bzw. den dort befindlichen Verstärkungen 5 zusammenfallen. Nach der Faltung und Kontaktierung der Netzwerke werden diese entlang den Trennlinien 9 in einzelne Netzwerke aufgetrennt.

Gemäß Fig. 3 wurde ein Netzwerk mit mehreren Kontaktflächen 10 versehen und mit äußeren Kontaktschichten kontaktiert. Dabei sind die Kontaktschichten ohne Unterbrechungen aufgebracht. Durch Schlitze 15, die zwischen je zwei Kontaktflächen 10 angebracht sind, ist eine äußere Kontaktschicht 7 in mehrere Abschnitte 17 aufgeteilt, die jeweils einer Kontaktfläche 10 zugeordnet und gegeneinander isoliert sind. Auf diese Weise läßt sich eine Vielzahl von Netzwerken darstellen, beispielsweise die Schaltung gemäß Fig. 4, bei der jeweils drei Widerstände einseitig mit einer gemeinsamen Kontaktfläche 11 verbunden sind, während die zweite Seite durch je eine Kontaktfläche 10 gesondert angeschlossen werden kann.

Sollen neben Widerständen auch andere Bauelemente in das Netzwerk integriert werden, so ist die Kunststoffolie 4 mit einer weiteren Metallschicht 13 auf duktilem Metall und diese mit einer weiteren Kunststoffschicht 14 verbunden. Hierbei ist die Summe der Dicken der Kunststoffschichten 4, der weiteren Metallschicht 13 und der weiteren Kunststoffschicht 14 etwa gleich der Dicke der Trägerfolie 1. Dadurch liegt auch hier die relativ spröde Widerstandsschicht 3 in der neutralen Faser des Aufbaus und wird beim Falten nicht unzulässig beansprucht. Um eine Kontaktierung zu ermöglichen, lassen die Kunststoffschicht 4, die Metallschicht 13 und die weitere Kunststoffschicht 14 auf beiden Seiten der Trägerfolie einen Randstreifen

0046975

frei. Dadurch kann die äußere Kontaktschicht 7 bzw. 8 (Fig.1) nach dem Falten die entsprechenden Kontaktflächen 3, 6 erreichen. Um die Kontaktierung der weiteren Metallschicht 13 zu ermöglichen, reicht die weitere Kunststoffschicht 14 nicht bis an den Rand der Metallschicht 13. Bei diesem Aufbau kann durch eine äußere Kontaktschicht im Bereich der Kontaktfläche 3 sowohl eine Kontaktierung dieser Kontaktflächen 3 als auch eine Durchkontaktierung zur weiteren Metallschicht 13 erfolgen.

Bei nicht allzu spröden Widerstandsmaterialien kann die Verstärkung 5 im Bereich der Faltkanten auch aus dem Widerstandsmaterial selbst bestehen. Aufgrund der mechanischen Festigkeit im Bereich der Verstärkung treten dann Risse weniger leicht auf.

Eine zusätzliche Verfestigung des Netzwerkes wird erreicht, indem die Faltkanten einer Reihe gegeneinander geringfügig versetzt sind.

Ein Abgleich des Netzwerkes, insbesondere durch Veränderung des Widerstandes, kann durch Materialabtrag auf den freiliegenden Teilen der Widerstandsbahnen erfolgen.

Die Trägerfolie kann mit einer durchgehenden Widerstandsschicht beschichtet sein. In diesem Fall kann der Faltstrang an beliebiger Stelle in Einzelwiderstände zertrennt und somit der Widerstandswert nach einer Messung des spezifischen Widerstandes am Faltstrang durch die Einstellung der Länge der abgetrennten Netzwerke eingestellt werden. Dadurch kann ein nachträglicher Abgleich der Widerstände auf einen Sollwert vermieden werden.

Patentansprüche

1. Elektrisches Netzwerk, welches zumindest einen elektrischen Widerstand enthält, welches aus einer mit zumindest einer Widerstandsschicht und mit Kontaktflächen beschichteten Trägerfolie aufgebaut ist, d a d u r c h  g e k e n n z e i c h n e t,  daß auf die Widerstandsschicht (2) eine Kunststoffschicht (4) aufgebracht ist, daß die Trägerfolie (1) so in einer Zick-Zack-Linie gefaltet ist, daß auf den beiden äußersten Lagen der Trägerfolie (1) auf der Außenseite der Trägerfolie (1) je eine Kontaktfläche (3, 6) liegt und daß äußere Kontaktschichten (7, 8) so aufgebracht sind, daß sie jeweils eine Kontaktfläche (6, 3) kontaktieren.

2. Elektrisches Netzwerk nach Anspruch 1, d a d u r c h  g e k e n n z e i c h n e t,  daß die Kontaktflächen von der Kunststoffschicht nicht vollständig bedeckt sind, daß die Kontaktflächen im Bereich je einer Reihe der Faltkanten liegen und daß die äußeren Kontaktschichten jeweils eine Reihe von Faltkanten umschließen und jeweils nur eine Kontaktfläche kontaktieren, während die jeweils andere Kontaktfläche und die Faltkanten durch die Kunststoffschicht gegenüber den äußeren Kontaktschichten isoliert sind.

3. Elektrisches Netzwerk nach einem der Ansprüche 1 oder 2, d a d u r c h  g e k e n n z e i c h n e t,  daß die Kunststoffschicht    annähernd dieselbe Dicke aufweist, wie die Trägerfolie und daß die Widerstandsschicht durch die Faltung nicht oder nur so geringfügig gedehnt ist, daß sie keine Risse oder andere Beschädigungen aufweist.

4. Elektrisches Netzwerk nach einem der Ansprüche 1 bis 3, d a d u r c h  g e k e n n z e i c h n e t,  daß die Widerstandsschicht aus Chromnickel besteht und daß sie um nicht mehr als 3% gedehnt ist.

5. Elektrisches Netzwerk nach einem der Ansprüche 1 bis 4, d a d u r c h   g e k e n n z e i c h n e t, daß die Widerstandsschicht im Bereich der Faltkanten durch ein duktiles Metall verstärkt ist.

6. Elektrisches Netzwerk nach einem der Ansprüche 1 bis 5, d a d u r c h   g e k e n n z e i c h n e t, daß das Netzwerk zumindest zwei nebeneinanderliegende Kontaktflächen aufweist und daß Schlitze durch die äußeren Kontaktschichten und zwischen den nebeneinanderliegenden Kontaktflächen angebracht sind.

7. Elektrisches Netzwerk nach Anspruch 1, d a d u r c h   g e k e n n z e i c h n e t, daß die einzelnen Falten miteinander stoffschlüssig verbunden sind und daß die äußeren Kontaktschichten jeweils eine der beiden freiliegenden Oberflächen der Trägerfolie bedecken.

8. Elektrisches Netzwerk nach Anspruch 1, d a d u r c h   g e k e n n z e i c h n e t, daß auf die Kunststoffschicht zumindest eine weitere Metallschicht und eine weitere Kunststoffschicht aufgebracht sind, daß die Metallschicht aus duktilem Metall besteht und weitere Bauelemente wie Kondensatoren und/oder Spulen bildet und daß die Kunststoffschicht, die weitere Kunststoffschicht und die Metallschicht zusammen etwa die Dicke der Trägerfolie aufweisen.

9. Verfahren zur Herstellung eines elektrischen Netzwerkes nach einem der Ansprüche 1 bis 8, d a d u r c h   g e k e n n z e i c h n e t, daß die mit Widerstandsschichten, Kontaktflächen und ggf. weiteren Schichten versehene Trägerfolie an ihren Rändern Kontaktflächen aufweist, daß die Kunststoffschicht unter Freilassung der Kontaktflächen aufgebracht wird, daß die Trägerfolie in ihrer Längsrichtung gefaltet wird, daß die äußeren Kontaktschichten aufgebracht werden und daß dann der so gebildete Faltstrang in einzelne Netzwerke zertrennt wird.

10. Verfahren nach Anspruch 9, d a d u r c h  g e k e n n -
z e i c h n e t,  daß unterschiedliche Muster von Widerstandsbahnen abwechselnd auf nur einer Trägerfolie erzeugt
werden und daß dadurch verschiedene Netzwerktypen abwechselnd hergestellt und daß diese beim Zertrennen auseinandersortiert werden.

11. Verfahren nach einem der Ansprüche 9 oder 10, d a -
d u r c h  g e k e n n z e i c h n e t,  daß zwischen
je zwei nebeneinanderliegenden Kontaktflächen auf einer
Seite der Trägerfolie metallfreie Streifen erzeugt werden
und daß der Faltstrang nach seiner Fertigstellung innerhalb dieser metallfreien Streifen eingesägt wird.

1/1

FIG 1

FIG 2

FIG 3

FIG 4

FIG 5